# EUROPEAN PATENT APPLICATION

(11) **EP 1 413 926 A2**
(43) Date of publication of application: **28.04.2004**
(21) Application number: 03254676.4
(22) Date of filing: 25.07.2003
(51) Int. Cl.: G03F 7/038

(54) **Photosensitive resin composition and printed wiring board**

(30) Priority: 30.09.2002 EP 02256799
(71) Applicant: Tamura Kaken Corporation, Irumi-shi, Saitama 358-8501 (JP)
(72) Inventor: Ono, Takao, Iruma-shi Saitama 358-8501 (JP); Miura, Ichiro, Iruma-shi Saitama 358-8501 (JP); Hasegawa, Yasuyuki, Iruma-shi Saitama 358-8501 (JP)
(74) Representative: Simons, Alison Diane

(57) **Abstract**

Disclosed is a photosensitive resin composition for use as a solder resist, which is free from anti-tackiness and excellent in flexibility, adhesiveness and heat resistance without other film properties being sacrificed, and can be easily designed so as to obtain properties in conformity with the end use thereof. This photosensitive resin composition comprises (A) an active energy ray-curable resin having at least two ethylenic unsaturated linkages per molecule, (B) a photopolymerization initiator, (C) a reactive diluent, and (D) a thermosetting compound; wherein the component (A) is constituted by a polybasic acid-modified unsaturated monocarboxylic acid-modified composite epoxy resin which is obtained by a process wherein a mixture comprising triglycidyl isocyanurate and a bisphenol type epoxy resin is allowed to react with a radically polymerizable unsaturated monocarboxylic acid to produce a compound having hydroxyl group with which a saturated or unsaturated polybasic acid or a saturated or unsaturated polybasic acid anhydride is reacted. There is also disclosed a printed wiring board formed using the aforementioned photosensitive resin composition.

## Description

### TECHNICAL FIELD

This invention relates to a photosensitive resin composition which is useful in forming an image by a process comprising a step of ultraviolet ray exposure and a step of development using a dilute aqueous alkaline solution, and is excellent not only in anti-tackiness (dry to touch) but also in film properties such as flexibility, adhesiveness and heat resistance without other film properties being sacrificed, i.e. other film properties being also maintained at an excellent level, thereby rendering the photosensitive resin composition suitable for use as a solder resist for producing a printed wiring board. This invention also relates to a printed wiring board formed by making use of such photosensitive resin composition as mentioned above.

### BACKGROUND OF THE INVENTION

The printed wiring board is employed for mounting electronic components on soldering lands of a conductive circuit pattern which has been formed in advance on the substrate of the printed wiring board, wherein all of the circuit regions excluding the soldering lands are covered by a solder resist film as a permanent protective film. By this covering of solder resist film, it becomes possible to prevent the solder from adhering onto regions which are not required to be coated with the solder on the occasion of soldering electronic components to the printed wiring board, and to prevent the conductor constituting the circuit pattern from being directly exposed to air and hence from being oxidized or corroded by moisture.

Conventionally, the solder resist film is formed, in most cases, by a process wherein a liquid composition of the solder resist film is coated on a substrate by means of a screen printing to form a pattern, which is then dried to remove a solvent and cured by means of ultraviolet rays or heating.

Recently however, due to the increasing demands for the enhancement in density (fineness) of wirings of the printed wiring board, a solder resist composition (referred hereinafter also as a solder resist ink composition) is also required to be more excellent in resolution as well as in precision. Under such circumstances, there has been proposed, in place of the conventional screen printing method and irrespective of the kinds of substrate i.e. consumer's use or industrial use, a liquid photosolder resist method (photodeveloping method) which is excellent in registration precision and in covering property of the edge portions of conductive body. For example, Japanese Patent Unexamined Publication S50-144431 and Japanese Patent Publication S51-40451 disclose solder resist compositions comprising bisphenol type epoxy acrylate, a sensitizer, an epoxy compound and an epoxy curing agent. These solder resist compositions are designed to be employed in such a manner that a liquid photosensitive composition is coated all over a printed wiring board, and after the solvent included therein is permitted to volatilize, the layer of the photosensitive composition is selectively exposed to irradiation, unexposed regions of the layer being subsequently removed by making use of an organic solvent to thereby perform the development of the solder resist.

However, the removal of the unexposure regions (development) by making use of an organic solvent necessitates a large quantity of the organic solvent, hence giving rise to environmental contamination or the generation of fire. Particularly, since the influence of the environmental contamination upon human body is high-lighted recently, the photosolder resist method is confronted with much difficulties for finding countermeasures for solving such problems.

With a view to solve these problems, there has been proposed an alkali-development type photosolder resist composition which can be developed by making use of a dilute aqueous alkaline solution. For example, Japanese Patent Publications S56-40329 and S57-45785 disclose a material comprising, as a base polymer, a reaction product which can be obtained by a process wherein an epoxy resin is reacted with unsaturated monocarboxylic acid to obtain a compound to which a poly-basic acid anhydride is added to obtain the reaction product. Further, Japanese Patent Publication H1-54390 discloses a photo-curable liquid resist ink composition which can be developed bymaking use of a dilute aqueous alkaline solution, this photo-curable liquid resist ink composition comprising an active energy beam-curable resin which can be obtained from a reaction between a saturated or unsaturated poly-basic acid anhydride and a reaction product obtained from a reaction between a novolac epoxy resin and an unsaturated monocarboxylic acid, and a photopolymerization initiator.

These liquid solder resist compositions are featured in that carboxylic group is introduced into epoxy acrylate to thereby provide them with photosensitivity and capability of being developed using a dilute aqueous alkali solution. These liquid solder resist compositions are further featured in that they usually include a thermosetting component, e.g. an epoxy compound in general, for thermosetting a coated film of these resist compositions after this coated film is formed into a resist pattern by way of exposure and development, thereby allowing a thermal curing to take place through a reaction between the carboxylic group introduced into a side chain of the epoxy acrylate and the epoxy group. As a result, it is possible to form a resist film which is excellent in adhesion, hardness, heat resistance and electric insulating properties. In this case, an epoxy resin-curing agent is generally employed together with the epoxy resin.

However, in the case of a solder resist composition comprising a resin that can be obtained by a process wherein unsaturated monocarboxylic acid is added to a novolac epoxy resin and then a polybasic acid is further added to the novolac epoxy resin, there is employed, for example, (metha)acrylic acid as the unsaturated monocarboxylic acid, and an unsaturated dibasic acid such as maleic acid is employed as the polybasic acid in order to obtain the resin, so that the resultant solder resist composition is somewhat insufficient in anti-tackiness . Additionally, even if it is intended to obtain a solder resist composition which is further improved in properties, in conformity with the object of use, such as heat resistance, flexibility of coated film required for gold plating resistance and adhesivity, it is difficult to design such a solder resist composition due to the facts that any of these reaction products to be bonded to the novolac epoxy resin is consisted of a chain compound where monomolecular compounds thereof are linked together, and that the kinds of such a monomolecular compound is limited so that the skeleton itself to be incorporated is of a relatively simple chain linkage thus limiting the range of selectivity. Namely, merely the changes of aforementioned chain compound to be bonded to the novolac epoxy resin are not sufficient for designing a satisfactory solder resist composition.

Therefore, a first object of the present invention is to provide a photosensitive resin composition which is useful in forming an image by a process comprising a step of ultraviolet ray exposure and a step of development using a dilute aqueous alkaline solution, and is excellent not only in anti-tackiness (dry to touch) but also in film properties such as flexibility, adhesiveness and heat resistance without other film properties being sacrificed, i.e.other film properties being also maintained at an excellent level, thereby rendering the photosensitive resin composition suitable for forming a pattern of coated film.

A second object of the present invention is to provide a photosensitive resin composition, whose characteristics can be easily designed in conformity with the end-use thereof, and which is capable of markedly improving the anti-tackiness and heat resistance thereof, especially the flexibility and adhesivity thereof so as to satisfactorily perform a gold plating.

A third object of the present invention is to provide a printed wiring board with or without an electronic component being mounted thereon, the printed wiring board being provided with a cured solder resist film constituted by the aforementioned photosensitive resin composition which is capable of achieving the aforementioned objects.

### BRIEF SUMMARY OF THE INVENTION

The present inventors have found, as a result of intensive studies for achieving the aforementioned objects, that a photosensitive resin composition comprising, in addition to ordinary components to be included therein, a resin which can be obtained by a process wherein a mixture comprising triglycidyl isocyanurate and bisphenol type epoxy resin is allowed to successively react with unsaturated monocarboxylic acid and with a polybasic acid is useful for forming a coated film which is excellent in anti-tackiness (not sticky) as well as for forming a cured film which is excellent in flexibility, in adhesion onto a substrate, and in heat resistance, and moreover that it is possible, through a selection of the mixing ratio between triglycidyl isocyanurate and bisphenol type epoxy resin, to markedly improve, among others, the anti-tackiness, heat resistance, flexibility and adhesivity-to-substrate of the coated film, thus accomplishing the present invention.

Namely, according to the present invention, there is provided (1) a photosensitive resin composition comprising (A) an active energy ray(line)-curable resin having ethylenic unsaturated linkage, (B) a photopolymerization initiator, (C) a diluent, and (D) a thermosetting compound; wherein said active energy line-curable resin having ethylenic unsaturated linkage (A) comprises a polybasic acid-modified unsaturated monocarboxylic acid-modified composite epoxy resin which is obtained by a process wherein a mixture comprising triglycidyl isocyanurate and a bisphenol type epoxy resin is allowed to react with a radically polymerizable unsaturated monocarboxylic acid to produce a compound having hydroxyl group with which a saturated or unsaturated polybasic acid or a saturated or unsaturated polybasic acid anhydride is reacted to obtain said polybasic acid-modified unsaturated monocarboxylic acid-modified composite epoxy resin.

According to the present invention, there is also provided (2) the photosensitive resin composition as set forth in the aforementioned item (1) , wherein said active energy ray-curable resin having ethylenic unsaturated linkage (A) has an acid value ranging from 50 to 180 mgKOH/g.

According to the present invention, there is also provided (3) the photosensitive resin composition as set forth in the aforementioned item (1) or (2) , wherein the mixing ratio of triglycidyl isocyanurate in the mixture comprising triglycidyl isocyanurate and bisphenol type epoxy resin is within the range of 30 to 90%.

According to the present invention, there is also provided (4) the photosensitive resin composition as set forth in any one of the aforementioned items (1) to (3),whereinsaid radically polymerizable unsaturated monocarboxylic acid is reacted with the mixture comprising triglycidyl isocyanurate and bisphenol type epoxy resin at a ratio of 0.4 to 0.9 mole per mole of the epoxy group of said mixture.

According to the present invention, there is also provided (5) the photosensitive resin composition as set forth in any one of the aforementioned items (1) to (4),whereinsaid radically polymerizable unsaturated monocarboxylic acid is reacted with the mixture comprising triglycidyl isocyanurate and bisphenol type epoxy resin to produce a reaction product having hydroxyl group with which a saturated or unsaturated polybasic acid or a saturated or unsaturated polybasic acid anhydride is reacted at a ratio of 0.7 to 2.0 moles per mole of the hydroxyl group of said reaction product.

According to the present invention, there is also provided (6) the photosensitive resin composition as set forth in any one of the aforementioned items (1) to (5), wherein said photopolymerization initiator (B) is employed at a ratio of 0.2 to 30g based on 100g of said active energy ray-curable resin having ethylenic unsaturated linkage (A).

According to the present invention, there is also provided (7) the photosensitive resin composition as set forth in any one of the aforementioned items (1) to (6) , wherein said diluent (C) is at least one kind of material selected from the group consisting of photopolymerizable monomers and organic solvents and is employed at a ratio of 2 to 40g based on 100g of said active energy ray-curable resin having ethylenic unsaturated linkage (A).

According to the present invention, there is also provided (8) the photosensitive resin composition as set forth in any one of the aforementioned items (1) to (7) , wherein said thermosetting compound (D) is constituted by an epoxy compound with or without other kind (s) of thermosetting compound (s) and is employed at a ratio of 5 to 100g based on 100g of said active energy ray-curable resin having ethylenic unsaturated linkage (A).

According to the present invention, there is also provided (9) a printed wiring board with or without an electronic component being mounted thereon, the printed wiring board being covered with a solder resist film constituted by a cured film of the aforementioned photosensitive resin composition as set forth in any one of the aforementioned items (1) to (8).

### DETAILED DESCRIPTION OF THE INVENTION

As for "(A) an active energy ray curable resin having at least two ethylenic unsaturated linkages in one molecule" according to the present invention is preferably constituted entirely by or alternatively may be constituted mainly by "a polybasic acid-modified unsaturated monocarboxylic acid-modified composite epoxy resin which is obtained by a process wherein a mixture comprising triglycidyl isocyanurate and a bisphenol type epoxy resin is allowed to react with a radically polymerizable unsaturated monocarboxylic acid to produce a compound having hydroxyl group with which a saturated or unsaturated polybasic acid or a saturated or unsaturated polybasic acid anhydride (it may be referred to hereinafter as a saturated or unsaturated polybasic acid or an anhydride thereof) is reacted to obtain said composite epoxy resin". It is also possible to co-use other kinds of polybasic acid-modified unsaturated monocarboxylic acid-modified epoxy resin which can be manufactured according to the same method as mentioned above except that another kind of epoxy resin (for example, novolac epoxy resin, etc.) other than the aforementioned mixture comprising triglycidyl isocyanurate and a bisphenol type epoxy resin is employed.

This triglycidyl isocyanurate has an isocyanuric acid skeleton, while the bisphenol type epoxy resin has a benzene ring. It is preferable that any of these compounds should be selected from polyfunctional epoxy compounds having a skeleton carrying a single or plurality of cyclic groups. The molecular weight of the epoxy compounds can be variously altered depending on the polymerization degree thereof. As for the epoxy equivalent of these epoxy compounds should, it is preferable to select from within the range of 80 to 500 in view of improving the photosensitivity of the polybasic acid-modified unsaturated monocarboxylic acid-modified composite epoxy resin to be ultimately obtained. As for the molecular weight of this composite epoxy resin, it is preferable to select from within the range of 200 to 1000 in view of the easiness in controlling the reaction in the synthesis of this composite epoxy resin.

As for the specific examples of triglycidyl isocyanurate, it is possible to employTEPIC-G (epoxy equivalent: 105; Nissan Chemical Industries, Ltd.). As for the bisphenol type epoxy resin, it is possible to employ, as bisphenol A, Epycoat 828 (epoxy equivalent: 190; liquid at normal temperature; Yuka Shell Co., Ltd.) and Epycoat 1001 (epoxy equivalent: 460; Yuka Shell Co., Ltd.).

As for the mixing ratio between triglycidyl isocyanurate and bisphenol type epoxy resin where the aforementioned polybasic acid-modified unsaturated monocarboxylic acid-modified composite epoxy resin is employed in a photosensitive resin composition, the larger the content of the former is, the greater the degree of improvement in anti-tackiness that can be obtained. Specifically, when the content of triglycidyl isocyanurate is at least 65% (65% or more), the anti-tackiness can be prominently improved. On the other hand, the larger the content of the latter is, the greater the degree of improvement that can be obtained in resilience of the cured coated film and also in the adhesion of the coated film to a printed circuit board. Specifically, when the content of bisphenol type epoxy resin is at least 50% (50% or more), the aforementioned resilience and adhesion can be prominently improved. Especially, when the content of bisphenol type epoxy resin is at least 65% (65% or more), it becomes possible to prominently improve "discoloration" as defined in the test of electric characteristics (a test to see if there is any discoloration of a cured coated film under the conditions wherein a DC voltage is impressed to the film at a high temperature and a high humidity). These excellent performances are of course far more excellent as compared with those of the conventional photosensitive resin composition where polybasic acid-modified unsaturated monocarboxylic acid-modified epoxy resin that can be obtained by making use of each one of the aforementioned epoxy compounds is employed. In addition to these excellent performances, the soldering heat resistance of the cured coated film (the heat resistance when a fused solder is contacted with the cured coated film) according to the present invention is also more excellent as compared with the aforementioned conventional photosensitive resin composition irrespective of the mixing ratio between triglycidyl isocyanurate and bisphenol type epoxy resin. As explained above, with regard to the aforementioned performances, the photosensitive resin composition according to the present invention is far excellent as compared with the conventional photosensitive resin composition irrespective of the mixing ratio between triglycidyl isocyanurate and bisphenol type epoxy resin. Additionally, with regard to other performances (sensitivity, heat control tolerance and various performances of coated film other than those mentioned above) also, it is possible according to the present invention to make them at least comparable to those of the conventional photosensitive resin composition.

As the aforementioned mixture comprising two kinds of epoxy compounds is permitted to react with the radically polymerizable unsaturated monocarboxylic acid, the epoxy group is cleaved due to the reaction between the epoxy group and the carboxyl group to thereby generate hydroxyl group and ester linkage. In this case, there is not any particular limitation regarding the kind of the radically polymerizable unsaturatedmonocarboxylic acid, so that it is possible to employ acrylic acid, methacrylic acid, crotonic acid, cinnamic acid, etc. However, it is preferable to employ at least either acrylic acid or methacrylic acid (which may be hereinafter referred to as (metha)acrylic acid), acrylic acid being most preferable. There is not any particular limitation regarding the reactingmethodbetween the epoxy resin and the radically polymerizable unsaturated monocarboxylic acid. For example, these epoxy resin and acrylic acid can be reacted by heating them in a suitable diluent. As for the diluent, it is possible to employ ketones such as methylethyl ketone, cyclohexanone, etc.; aromatic hydrocarbons such as toluene, xylene, etc.; alcohols such as methanol, isopropanol, cyclohexanol, etc.;alicyclic hydrocarbonssuch as cyclohexane,methylcyclohexane, etc.; petroleum solvents such as petroleum ether, petroleum naphtha, etc.; Cellosolves such as Cellosolve, butyl Cellosolve, etc.; carbitols such as carbitol, butyl carbitol, etc.; and acetic esters such as ethyl acetate, butyl acetate, Cellosolve acetate, butyl Cellosolve acetate, carbitol acetate, butylcarbitol acetate, etc. As for the catalyst to be employed in this case, it is possible to employ amines such as triethyl amine, tributyl amine, etc.; and phosphides such as triphenyl phosphine, triphenyl phosphate, etc.

In the reaction between the aforementioned mixture of two kinds of epoxy compounds and the radically polymerizable unsaturated monocarboxylic acid, polyfunctional epoxy compounds having two or more epoxy groups in one molecule is employed as each of the epoxy compounds. In this case, it is preferable that 0.4 to 0.9 mole, i.e. less than one mole, of the radically polymerizable unsaturated monocarboxylic acid is permitted to react with each mole of epoxy group (one equivalent) of the mixture of two kinds of epoxy compounds. In this case, as the ratio of the radically polymerizable unsaturated monocarboxylic acid to be reacted with the aforementioned mixture becomes much smaller than one mole, it becomes possible to easily enable the molecule of other kinds of epoxy compound to be added to the hydroxyl group that can be generated from the addition of the radically polymerizable unsaturated monocarboxylic acid to one kind of molecule of epoxy compound, or to the carboxyl group that can be generated from the reaction of a saturated or unsaturated polybasic acid or an anhydride thereof to be subsequently reacted. As a result, two kinds of epoxy compounds that have been used as a mixture can be easily turned into a resin where a plurality of molecules thereof are bonded to each other. On the contrary, as the ratio of the radically polymerizable unsaturated monocarboxylic acid to be reacted with the aforementioned mixture becomes much larger than one mole, the resultant mixture is more likely to be formed of a mixture comprising adducts of the radically polymerizable unsaturated monocarboxylic acid with each of the aforementioned two kinds of epoxy compounds employed. If the ratio of the radically polymerizable unsaturated monocarboxylic acid to be reacted with the aforementionedmixture is less than 0.4 mole, the photosensitivity of the photosensitive resin would be deteriorated, thereby making it difficult to form an image of pattern, and moreover, since the ratio of inter-linkage between epoxy compounds is increased, it would lead to an increase of molecular weight, the deterioration of thermal stability and the generation of gelation.

In the reaction between the aforementioned mixture of two kinds of epoxy compounds and the radically polymerizable unsaturated monocarboxylic acid in a diluent, the content of the diluent should preferably be confined within the range of 20 to 50% based on the entire weight of the reaction system. In this case, the reaction product can be prevented, as a solution in the diluent, without necessitating the isolation of the reaction product between the epoxy compounds and the radically polymerizable unsaturated monocarboxylic acid, to the next step where the reaction product is reacted with a saturated or unsaturated polybasic acid or the anhydride thereof.

An unsaturated monocarboxylic acid-modified epoxy compound which is a reaction product between the aforementioned mixture of two kinds of epoxy compounds and the radically polymerizable unsaturated monocarboxylic acid is then allowed to react with a saturated or unsaturated polybasic acid or the anhydride thereof to obtain the aforementioned polybasic acid-modified unsaturated monocarboxylic acid-modified composite epoxy resin. As for the saturated or unsaturated polybasic acid useful in this case, it is possible to employ succinic acid, maleic acid, adipic acid, citric acid, phthalic acid, tetrahydrophthalic acid, 3-methyltetrahydrophthalic acid, 4-methyltetrahydrophthalic acid, 3- ethyltetrahydrophthalic acid, 4- ethyltetrahydrophthalic acid, hexahydrophthalic acid, 3- methylhexahydrophthalic acid, 4-methylhexahydrophthalic acid, 3- ethylhexahydrophthalic acid, 4-ethylhexahydrophthalic acid, methyltetrahydrophthalic acid, methylhexahydrophthalic acid, endomethylenetetrahydrophthalic acid, methylendomethylenetetrahydrophthalic acid, trimellitic acid, pyromellitic acid, and diglycolic acid. As for the polybasic acid anhydride, it is possible to employ anhydrides of these polybasic acids. These compounds can be employed singly or in combination of two kinds thereof.

The saturated or unsaturated polybasic acid or the anhydride thereof is then allowed to react with the hydroxyl group that has been generated from the reaction between the aforementioned mixture comprising two kinds of epoxy compounds and the radically polymerizable unsaturated monocarboxylic acid, thereby providing them with free carboxyl group. The quantity to be employed of the saturated or unsaturated polybasic acid or anhydrides thereof for the reaction should preferably be confined within the range of 0.7 to 2.0 moles per mole of the hydroxyl group attached to the reaction product obtained through the reaction between the aforementioned mixture comprising two kinds of epoxy compounds and the radically polymerizable unsaturated monocarboxylic acid. It is more preferable, in view of enabling a resin film to obtain a high sensitivity on the occasion of exposure, to perform the reaction by confining the ratio of the polybasic acid or anhydrides thereof to 1.0 to 1.8 moles per mole of the hydroxyl group. If the ratio of the polybasic acid or anhydrides thereof is less than 0.7 mole, the dilute alkali developing property of the resin to be ultimately obtained would be deteriorated. On the other hand, if the ratio of the polybasic acid or anhydrides thereof exceeds over 2.0 moles, various properties (for example, waterproofness) of the cured coated film to be ultimately obtained would be deteriorated.

The saturated or unsaturated polybasic acid or the anhydride thereof is added to the aforementioned unsaturated monocarboxylic acid-modified epoxy compound so as to allow a dehydrocondensation reaction to take place. The water that has been generated in this reaction should preferably be continuously taken out of the reaction system. It is preferable that this reaction is performed under a heated condition at a temperature of 70-130°C. If the reaction temperature is higher than 130°C, the thermal polymerization of the radically polymerizable unsaturated groups that have been bonded to the epoxy resin or that can be derived from unreacted monomer may be easily caused to take place, thereby making it difficult to perform the synthesis. On the other hand, if this reaction temperature is lower than 70°C, the speed of reaction would become too slow and therefore is not preferable in the actual manufacturing process.

The acid value of the polybasic acid-modified unsaturated monocarboxylic acid-modified composite epoxy resin to be obtained in this manner should preferably be within the range of 50 to 180 mgKOH/g. If the acid value of this composite epoxy resin is less than this lower limit, the developing property of the photosensitive resin composition employing this composite epoxy resin would be deteriorated. On the other hand, if the acid value of this composite epoxy resin is larger than this upper limit, it would become difficult to improve the properties such as waterproofness of the cured film of the photosensitive resin composition comprising this composite epoxy resin.

Although the aforementioned polybasic acid-modified unsaturated monocarboxylic acid-modified composite epoxy resin can be employed as a photosensitive resin, a radically polymerizable unsaturated groupmaybe further introduced into this composite epoxy resin through a reaction between the carboxyl group of this composite epoxy resin and a glycidyl compound having at least one radically polymerizable unsaturated group and epoxy group, thereby obtaining a photosensitive resin which is further improved in photosensitivity.

Since this photosensitive resin which is further improved in photosensitivity is featured in that the radically polymerizable unsaturated group is bonded to the side chain of the polymeric skeleton of the photosensitive resin constituting the precursor thereof due to the last reaction thereof with the glycidyl compound, the photopolymerization reactivity thereof is further enhanced, thus exhibiting excellent photosensitive properties. As for the glycidyl compound having at least one radically polymerizable unsaturated group and epoxy group, it is possible to employ glycidyl acrylate, glycidyl methacrylate, allyl glycidyl ether, pentaerythritol triacrylate monoglycidyl ether, etc. By the way, the molecule of these compounds may contain a plurality of glycidyl groups. These compounds may be employed singly or in combination of two or more kinds thereof.

These glycidyl compounds can be mixed into a solution of the polybasic acid-modified unsaturated monocarboxylic acid-modified composite epoxy resin so as to allow the reaction thereof to take place. In this case, the reaction is executed by incorporating the glycidyl compound to the solution generally at a ratio of 0.05-0.5 mole per mole of the carboxyl group that has been introduced into the epoxy resin. In view of various factors such as the photosensitivity (sensitivity) of the photosensitive resin composition containing a photosensitive resin that can be obtained, the heat control tolerance (the controllable range of thermal tolerance relative to the degree of curing of coated film that can be removed on the occasion of developing the unexposure regions at the step of drying the coated film), and the electric properties such as electric insulation, it would be more advantageous to execute the reaction by incorporating the glycidyl compound at a ratio of 0 . 1-0 . 5 mole per mole of the carboxyl group. The reaction temperature in this case should preferably be within the range of 80-120°C. The acid value of the photosensitive resin which is composed of this glycidyl compound-added polybasic acid-modified unsaturated monocarboxylic acid-modifiedcomposite epoxy resin should preferably be within the range of 60-250 mgKOH/g.

According to the present invention, the photosensitive resin composition is accomplished by mixing therein (B) a photopolymerization initiator, (C) a reactive diluent and (D) a thermosetting compound in addition to the aforementioned (A). this photosensitive resin composition is suited for use as a solder resist composition for manufacturing a printed wiring board for instance.

As for the aforementioned (B) a photopolymerization initiator, there is not any particular limitation and hence any known materials can be employed. Representative examples thereof include benzoin, benzoin methyl ether, benzoin ethyl ether, benzoin isopropyl ether, benzoin-n-butyl ether, benzoin isobutyl ether, acetophenone, dimethylamino acetophenone, 2,2-dimethoxy-2-phenyl acetophenone, 2,2-diethoxy-2-phenyl acetophenone, 2-hydroxy-2-methyl-1-phenylpropan-1-one, 1-hydroxycyclohexylphenyl ketone, 2-methyl-1-[4-(methylthio)phenyl]-2-morpholino-propan-1-one, 4-(2-hydroxyethoxy)phenyl-2-(hydroxyl-2-propyl) ketone, benzophenone, p-phenyl benzophenone, 4,4'-diethylamino benzophenone, dichloro benzophenone, 2-methylanthraquinone, 2-ethylanthraquinone, 2-tertiary-butylanthraquinone, 2-aminoanthraquinone, 2-methylthioxanthone, 2-ethylthioxanthone, 2-chlorothioxanthone, 2,4-dimethylthioxanthone, 2,4-diethylthioxanthone, benzyldimethyl ketal, acetophenone dimethyl ketal, p-dimethylamino benzoic ethylester, etc. these compounds can be employed singly or in combination of two or more kinds thereof.

The mixing ratio of the photopolymerization initiator may be generally in the range of 0.5-50g based on 100g of the active energy ray-curable resin constituting the component (A). If the mixing ratio of the photopolymerization initiator is less than 0.5g, it would become difficult to enable the active energy ray-curable resin to proceed the photo-curing reaction thereof. On the other hand, even if the mixing ratio of the photopolymerization initiator is increased exceeding over 50g, it is impossible to further enhance the effects expected of the photopolymerization initiator, and hence an excessive addition of the photopolymerization initiator is economically disadvantageous. Furthermore, any excessive addition of the photopolymerization initiator may invite the deterioration of the mechanical properties of the cured film thereof . In viewpoints of the photo-curing properties, economy and mechanical properties of cured film, the mixing ratio of the photopolymerization initiator should preferably be in the range of 2.0-30g based on 100g of the active energy ray-curable resin.

The reactive diluent (C) is constituted by at least one kind of materials selected from a photo-polymerizable monomer and an organic solvent. This photo-polymerizable monomer is also called a reactive diluent and is useful in promoting the photo-curing of the photosensitive resin constituting the component (A). Therefore, the reactive diluent (C) should preferably be employed for obtaining a coated film which is excellent in acid resistance, heat resistance and alkali resistance. Preferably, the photo-polymerizable monomer should be selected from compounds having at least two double bonds in each molecule. An organic solvent may be employed for the purpose of adjusting the viscosity and drying property of the photosensitive resin composition comprising the active energy ray-curable resin (photosensitive resin) constituting the aforementioned component (A). However, the organic solvent may not be employed if the employment thereof is not required. Further, if the photo-curability of the photosensitive resin constituting the aforementioned component (A) is sufficiently large in magnitude, the photo-polymerizable monomer may not be employed.

As for the specific examples of the photo-polymerizable monomer, it is possible to employ various kinds of reactive diluents such as 1,4-butanediol di(metha)acrylate, 1,6-hexanediol di(metha)acrylate, neopentylglycol di(metha)acrylate, polyethyleneglycol di(metha)acrylate, neopentylglycol diadipate di(metha)acrylate, hydroxyl pivalic acid neopentylglycol di(metha)acrylate, dicyclopentanyl di(metha)acrylate, caprolactone-modified dicyclopentenyl di(metha)acrylate, ethylene oxide-modified phosphoric acid di(metha)acrylate, allylcyclohexyl di(metha)acrylate, isocyanurate di(metha)acrylate, trimethylolpropane tri(metha)acrylate, dipentaerythritol tri(metha)acrylate, propionic acid-modified dipentaerythritol tri(metha)acrylate, pentaerythritol tri(metha)acrylate, propylene oxide-modified trimethylolpropane tri(metha)acrylate, tris(acryloxyethyl)isocyanurate, propionic acid-modified dipentaerythritol penta(metha)acrylate, dipentaerythritol hexa(metha)acrylate, caprolactone-modified dipentaerythritol hexa(metha)acrylate, etc.

The aforementioned 2 to 6-functional as well as other polyfunctional reactive diluents may be employed singly or in combination of two or more kinds. The mixing ratio of these reactive diluents may be selected generally from the range of 2.0 to 40g per 100g of the active energy line-curable resin constituting the component (A). If the mixing ratio of these reactive diluents is less than 2.0g, it would be impossible to achieve a sufficient photo-curing and to obtain satisfactory properties in terms of acid resistance and heat resistance of the cured film thereof. On the other hand, even if the mixing ratio of these reactive diluents is increased exceeding over 40g, the cured film thereof would become excessively high in tackiness, thereby easily generating the adhesion of the cured film onto the substrate of art work film in the step of exposure, thus making it difficult to obtain a desirable cured film.

In view of various factors such as photo-curing property, the acid resistance and heat resistance of cured film, and the prevention of adhesion onto the substrate of art work film, the mixing ratio of the reactive diluent should more preferably be within the range of 4.0 to 20g per 100g of the active energy line-curable resin.

As for the specific examples of the aforementioned organic solvent useful in this case, they include ketones such as methylethyl ketone, cyclohexanone, etc.; aromatic hydrocarbons such as toluene, xylene, etc.; alcohols such as methanol, isopropanol, cyclohexanol, etc.; alicyclic hydrocarbons such as cyclohexane, methylcyclohexane, etc.; petroleum solvents such as petroleum ether, petroleum naphtha, etc.; Cellosolves such as Cellosolve, butyl Cellosolve, etc.; carbitols such as carbitol, butyl carbitol, etc.; and acetic esters such as ethyl acetate, butyl acetate, Cellosolve acetate, butyl Cellosolve acetate, carbitol acetate, butylcarbitol acetate, etc. As for the catalyst to be employed in this case, it is possible to employ amines such as triethyl amine, tributyl amine, etc.; and phosphides such as triphenyl phosphine, triphenyl phosphate, etc.

The aforementioned thermosetting compound (D) in the photosensitive resin composition of the present invention is useful for improving the properties of the coated film after the post-curing thereof which is performed in subsequent to the steps of exposure and development of the coated film. Specific examples this thermosetting compound (D) include, in addition to the aforementioned two kinds of epoxy compounds, other kinds of thermosetting compounds such as triglycidyl amine compounds (e.g. TEPIC-S (Nissan Chemical Industries, Ltd.; epoxy equivalent: 100; glass transition temperature: 98-120°C) ; Araldite MY-720 (Chiba Co., Ltd. ) ; and TMH574 (Sumitomo Chemical Industries, Ltd.)); bisphenol type epoxy resin (e.g. YL-4000 (Yuka Shell Co., Ltd.; 2,6-xylenol dimmer diglycidyl ether; epoxy equivalent: 188; glass transition temperature: 105-110°C; and YL-6121 (Yuka Shell Co., Ltd.; epoxy equivalent: 172; glass transition temperature: 111°C) ) ; aliphatic epoxy resins (e.g. Araldite CY-179 (Chiba Co., Ltd.)); dicyclopentadiene type epoxy resin which is based on a modified polyhyric phenol resin which can be obtained through a polyaddition reaction between dicyclopentadiene and phenol in the presence of Lewis acid catalyst; xylene type epoxy resin such as EXA-4580L (Dainihon Ink Chemicals Industries); naphthalene type epoxy resin such as tetrafunctional naphthalene skeleton type epoxy resin which can be manufactured for example by a method set forth in Japanese Patent Unexamined Publication H4-217675. The aforementioned dicyclopentadiene type epoxy resin and naphthalene type epoxy resin can be turned into a cured body which is low in water absorption.

This thermosetting compound (D) can be employed at a mixing ratio ranging from 5 to 150g in general per 100g of the active energy ray-curable resin constituting the component (A). If the mixing ratio of this thermosetting compound is less than 5g, it would be impossible to achieve a sufficient photo-curing and to obtain satisfactory properties in terms of adhesivity, heat resistance and gold-plating resistance, which are required for the post-cured solder resist film of the present invention. On the other hand, even if the mixing ratio of this thermosetting compound is increased exceeding over 150g, the developing property of the coated film prior to the post curing would be deteriorated, thereby deteriorating the pot life stability of the photosensitive composition. In view of these facts, the mixing ratio of this epoxy thermosetting compound should preferably be in the range of 50-100g per 100g of the active energy line-curable resin.

This epoxy thermosetting compound may be employed together with at least one kind of reaction-promoting agent selected from dicyan diamide, organic acid salts of dicyan diamide and the derivatives thereof; or with a known epoxy curing promoting agent such as melamine compounds, imidazole compounds and phenol compounds, thereby making it possible to further promote the post-curing of the coated film. The photosensitive resin composition according to the present invention, which contains a suitable quantity of a latent thermal curing agent constituted by an organic acid salt of dicyanine diamide or the derivatives thereof is excellent in pot life as well as in storage stability as compared with the photosensitive resin composition using dicyanine diamide or N-substituted dicyanine diamide. Additionally, the coated film of the photosensitive resin composition according to the present invention is capable of extending the thermal control tolerance thereof. The mixing ratio of the reaction-promoting agent may be selected from the range of 0.1-10g per 100g of the component (A).

When the aforementioned thermal curing compound is employed singly or together with the aforementioned reaction-promoting agent, it becomes possible to improve various properties such as heat resistance, moisture resistance, electric insulating property, chemical resistance, acid resistance, adhesivity, flexibility and hardness, so that this thermal curing compound is suited for use as a solder resist for the manufacture of printed wiring boards.

The photosensitive resin composition according to the present invention may further contain various kinds of additives as required in addition to the aforementioned components, specific examples of such additives including a filler consisting of inorganic pigment (s) such as silica, alumina, talc, calcium carbonate, barium sulfate, etc.; a known coloring pigment such as an organic pigment such as phthalocyanine green, phthalocyanine blue, etc. and an inorganic pigment such as titanium dioxide; an antifoaming agent; a leveling agent; etc.

The photosensitive resin composition according to the present invention which can be obtained as explained above can be coated to a desired thickness on the surface of a printed wiring board provided with a circuit pattern which can be formed by etching a copper foil of a copper-clad laminated board. The resultant coated film is then heated for 15-60 minutes at a temperature of 60-80°C to evaporate the solvent, after which a negative film having a circuit pattern which is made light-transmissive except regions where soldering lands are located is adhered onto the coated film. Thereafter, the printed wiring board is irradiatedwith ultraviolet rays from over the negative film, and the unexposure portions corresponding to the soldering lands are removed by making use of a diluted aqueous alkaline solution to thereby develop the coated film. As for the diluted aqueous alkaline solution to be employed in this case, although 0.5-5wt% aqueous solution of sodium carbonate is usually employed, it is also possible to employ other kinds of alkaline solution.

Then, the pattern of the coated film is subjected to post curing for 10-60 minutes by making use of a hot air circulate type dryer which is heated up to a temperature of 140-160°C to thereby obtain an aimed solder resist film.

As a result, a printed wiring board having a solder resist film formed thereon can be obtained. Thereafter, electronic devices can be soldered and secured onto the surface of the printed wiring board by means of a jet flow soldering method or a reflow soldering method, thus accomplishing a single electronic circuit unit.

The present invention includes as a scope thereof not only a printed wiring board covered with a solder resist film before an electronic component is mounted thereon, but also a printed wiring board having an electronic component mounted thereon.

It should be noted that the present invention is intended to cover broader concepts with respect to each of the components and to the ratios thereof centering on those employed in the following Examples, so that the employment of analogous compounds to those described above at the aforementioned preferable ranges in ratio of these compounds is possible in the present invention.

### Examples:

Next, the present invention will be further explained with reference to the following examples, which are not intended to limit the present invention.

### Resin manufacturing example 1 (photosensitive resin as the aforementioned component (A); the same in the following resin manufacturing examples 2 and 3):

210g of triglycidyl isocyanurate (Nissan Chemical Industries, Ltd.; TEPIC-G; epoxy equivalent: 105), 480g of bisphenol type epoxy resin (Yuka Shell Co., Ltd.; Epycoat 1001; epoxy equivalent: 480) and 130g of acrylic acid were dissolved in 690g of carbitol acetate and allowed to react under reflux to obtain epoxy acrylate. Then, to this epoxy acrylate, 462g of hexahydrophthalic anhydride was added to obtain a mixture, which was then allowed to react under reflux until the acid value of the solution of the reaction product became 51 mgKOH/g. The solution of photosensitive resin thus obtained was found to contain 65% of solid resin moiety, and the acid value of this resin moiety was 79 mgKOH/g.

### Resin manufacturing example 2:

210g of triglycidyl isocyanurate (Nissan Chemical Industries, Ltd. ; TEPIC-G; epoxy equivalent: 105) , 240g of bisphenol type epoxy resin (Yuka Shell Co., Ltd.; Epycoat 1001; epoxy equivalent: 480) and 108g of acrylic acid were dissolved in 507g of carbitol acetate and allowed to react under reflux to obtain epoxy acrylate. Then, to this epoxy acrylate, 385g of hexahydrophthalic anhydride was added to obtain a mixture, which was then allowed to react under reflux until the acid value of the solution of the reaction product became 58 mgKOH/g. The solution of photosensitive resin thus obtained was found to contain 65% of solid resin moiety, and the acid value of this resin moiety was 89 mgKOH/g.

### Resin manufacturing example 3:

420g of triglycidyl isocyanurate (Nissan Chemical Industries, Ltd.; TEPIC-G; epoxy equivalent: 105) , 240g of bisphenol type epoxy resin (Yuka Shell Co., Ltd.; Epycoat 1001; epoxy equivalent: 480) and 216g of acrylic acid were dissolved in 803g of carbitol acetate and allowed to react under reflux to obtain epoxy acrylate. Then, to this epoxy acrylate, 616g of hexahydrophthalic anhydride was added to obtain a mixture, which was then allowed to react under reflux until the acid value of the solution of the reaction product became 61 mgKOH/g. The solution of photosensitive resin thus obtained was found to contain 65% of solid resin moiety, and the acid value of this resin moiety was 94 mgKOH/g.

### Resin manufacturing example 4 (comparative example):

480g of bisphenol type epoxy resin (Yuka Shell Co. , Ltd. ; Epycoat 1001; epoxy equivalent: 480) and 72g of acrylic acid were dissolved in 380g of carbitol acetate and allowed to react under reflux to obtain epoxy acrylate. Then, to this epoxy acrylate, 154g of hexahydrophthalic anhydride was added to obtain a mixture, which was then allowed to react under reflux until the acid value of the solution of the reaction product became 52 mgKOH/g. The solution of photosensitive resin thus obtained was found to contain 65% of solid resin moiety, and the acid value of this resin moiety was 79 mgKOH/g.

### Resin manufacturing example 5 (comparative example):

380g of bisphenol type epoxy resin (Yuka Shell Co. , Ltd. ; Epycoat 828; epoxy equivalent: 190) and 144g of acrylic acid were dissolved in 365g of carbitol acetate and allowed to react under reflux to obtain epoxy acrylate. Then, to this epoxy acrylate, 154g of hexahydrophthalic anhydride was added to obtain a mixture, which was then allowed to react under reflux until the acid value of the solution of the reaction product became 54 mgKOH/g. The solution of photosensitive resin thus obtained was found to contain 65% of solid resin moiety, and the acid value of this resin moiety was 83 mgKOH/g.

### Resin manufacturing example 6 (comparative example):

315g of triglycidyl isocyanurate (Nissan Chemical Industries, Ltd.; TEPIC-G; epoxy equivalent: 105) and 216g of acrylic acid were dissolved in 369g of carbitol acetate and allowed to react under reflux to obtain epoxy acrylate. Then, to this epoxy acrylate, 154g of hexahydrophthalic anhydride was added to obtain a mixture, which was then allowed to react under reflux until the acid value of the solution of the reaction product became 53 mgKOH/g. The solution of photosensitive resin thus obtained was found to contain 65% of solid resin moiety, and the acid value of this resin moiety was 81 mgKOH/g.

### Example 1:

8g of 2-methyl-1-[4-(methylthio)phenyl]-2-morpholino-1-propan-1-one ((B) a photopolymerization initiator), 8g of trimethylolpropane triacrylate ((C) a reactive diluent), 8g of triglycidyl tris(2-hydroxymethyl)isocyanurate ((D) a thermosetting compound), 0.5g of phthalocyanine green, and 8g of talc were added to 100g of the solution of photosensitive resin ((A) a photosensitive resin) which was obtained in the above resin manufacturing example 1 to obtain a mixture, which was then mixed together and dispersed by making use of a three-roll mill to thereby prepare a solution of photosensitive resin composition.

Then, this photosensitive resin composition was investigated by way of the following testing methods with respects to sensitivity, heat control tolerance, anti-tackiness, soldering heat resistance, acid resistance, adhesivity, solvent resistance, gold plating resistance and electric properties (insulation resistance and discoloration), the results being shown in Table 1.

### Examples 2 and 3:

The solutions of photosensitive resin compositions were prepared in the same manner as described in Example 1 except that the solutions of the photosensitive resin compositions obtained in the above resin manufacturing examples 2 and 3 were respectively substituted for the solution of the photosensitive resin composition obtained in the above resin manufacturing example 1, and the tests of the solutions were made in the same manner as described in Example 1, the results being shown in Table 1.

### Comparative Examples 1 to 3:

The solutions of photosensitive resin compositions were prepared in the same manner as described in Example 1 except that the solutions of the photosensitive resin compositions obtained in the above resin manufacturing examples 4 to 6 were respectively substituted for the solution of the photosensitive resin composition obtained in the above resin manufacturing example 1, and the tests of the solutions were made in the same manner as described in Example 1, the results being shown in Table 1.

The details of these testing methods are as follows.

### (1) Sensitivity:

A layer 35 *µ*m in thickness (before drying) of the photosensitive resin composition of each of the above Examples 1-3 and Comparative Examples 1-3 was coated on a test plate by means of screen printing method to form a 21-step tablet and then dried to prepare a coated substrate. Thereafter, the layer of the photosensitive resin composition was subjected at first to an ultraviolet irradiation at an exposure dose of 200 mJ/cm² and then to a development process by making use of 1% aqueous solution of sodium carbonate and at a spray pressure of 0.2 MPa·s during 60 seconds. The sensitivity of the photosensitive resin composition was evaluated based on the maximum number of steps where the coated film had been completely left remained. The larger the maximum number of steps is, the more excellent the photosensitivity of the photosensitive resin composition is.

### (2) Anti-tackiness (dry to touch):

A layer 35 *µ*m in thickness (before drying) of the photosensitive resin composition of each of the above Examples 1-3 and Comparative Examples 1-3 was coated on a pre-surface-treated substrate (a copper-clad laminate plate) by means of screen printing method and then dried for 20 minutes at a temperature of 80°C to prepare a coated substrate. Thereafter, a negative film was adhered onto the surface of the coated layer. After being subjected to an exposure process, the magnitude of adhesion of the coated layer to the negative film was investigated and evaluated as follows.
ⓞ The adhesion or the trace of adhesion was not recognized at all.
○ The trace of adhesion was recognized on the surface of the coated layer.
Δ There was recognized resistance in peeling the negative film.
× There was recognized an adhered matter of the coated layer on the surface of the negative film.

### (3) Heat control tolerance:

A layer 35 *µ*m in thickness (before drying) of the photosensitive resin composition of each of the above Examples 1-3 and Comparative Examples 1-3 was coated on a pre-surface-treated substrate (a copper-clad laminate plate) by means of screen printing method and then dried in such a manner that the time of preliminary drying at a temperature of 80°C was prolonged at an interval of 10 minutes to prepare various coated substrates. Thereafter, the layer of the photosensitive resin composition of each of these various coated substrates was subjected at first to an ultraviolet irradiation at an exposure dose of 200 mJ/cm² and then to a development process by making use of 1% aqueous solution of sodium carbonate and at a spray pressure of 0.2 MPa·s during 60 seconds. The heat control tolerance of the photosensitive resin composition was evaluated based on the longest time of preliminary drying which enabled the coated film to be completely removed.

### (4) Characteristics of coated film:

A layer 35 *µ*m in thickness (before drying) of the photosensitive resin composition of each of the above Examples 1-3 and Comparative Examples 1-3 was coated on a pre-surface-treated substrate (a copper-clad laminate plate) by means of screen printing method to obtain various kinds of coated substrates, each of which was then dried for 20 minutes at a temperature of 80°C. Thereafter, a negative film was adhered onto the surface of each coated layer. After being subjected to an exposure process, each of the coated substrates was subjected to a development process by making use of 1 wt% aqueous solution of sodium carbonate to form a pattern. Then, each of the coated substrate was allowed to thermally cure for 60 minutes at a temperature of 150°C to thereby prepare test pieces each having a cured film thereon. Then, the characteristics of coated films were evaluated as follows.

### (a) Pencil hardness:

The coated films were evaluated based on JIS K-5400 6.14.

### (b) Soldering heat resistance:

The test pieces each having the cured film formed thereon were evaluated according to the testing method set forth in JIS C 6481. Namely, each of the test pieces was immersed for 30 seconds in a solder tank maintained at a temperature of 260°C. Then, a cycle of peeling test using a Cellophane (tradename) adhesive tape was repeated up to three times to evaluate the condition of the coated film by way of visual observation.
ⓞThere was no change in the coated film even after three cycles of peeling test.
○ There was recognized slight changes in the coated film after three cycles of peeling test.
Δ There was recognized changes in the coated film after two cycles of peeling test.
× There was recognized the peeling of the coated film after one cycle of peeling test.

### (c) Acid resistance:

The test pieces each having the cured film formed thereon were immersed for 30 minutes in 10 wt% aqueous solution of sulfuric acid at normal temperature. Then, after being water-washed, a peeling test using a Cellophane adhesive tape was performed to visually evaluate the acid resistance of the coated film through the observation of the peeling and discoloration of the coated film.
ⓞThere was no change in the coated film.
○ There was recognized slight changes in the coated film.
Δ There was recognized prominent changes in the coated film.
× The coated film was swelled and peeled.

### (d) Solvent resistance:

The test pieces each having the cured film formed thereon were immersed for 30 minutes in methylene chloride at normal temperature. Then, after being water-washed, a peeling test using a Cellophane adhesive tape was performed to visually evaluate the solvent resistance of the coated film through the observation of the peeling and discoloration of the coated film.
ⓞ There was no change in the coated film.
○ There was recognized slight changes in the coated film.
Δ There was recognized prominent changes in the coated film.
× The coated film was swelled and peeled.

### (e) Gold-plating resistance:

The test pieces each having the cured film formed thereon were subjected to a gold-plating work. Then, a peeling test using a Cellophane adhesive tape was performed to visually evaluate the gold-plating resistance of the coated film through the observation of the peeling and discoloration of the coated film.
ⓞ There was no change in the coated film.
○ There was recognized slight changes in the coated film.
Δ There was recognized prominent changes in the coated film.
× The coated film was swelled and peeled.

### (f) Electric properties:

A tandem electrode B coupon of IPC SM-840B, B-25 was placed on the cured film of a test piece. Then, a DC voltage of 100V was applied to the cured film in a thermohygrostat which was maintained at a temperature of 60°C and a relative humidity of 90% to thereby measure the insulation resistance (Ω) 500 hours later. At the same time, the discoloration of the coated film was observed to visually evaluate the degree of discoloration.
ⓞ There was no change in the coated film.
○ There was recognized slight changes in the coated film.
Δ There was recognized prominent changes in the coated film.
× The coated film was swelled and peeled.

**Table 1**

| | | Example | | | Comp.EX. | | |
|---|---|---|---|---|---|---|---|
| | | 1 | 2 | 3 | 1 | 2 | 3 |
| Sensitivity | | 9 | 9 | 10 | 8 | 9 | 9 |
| Anti-tackiness | | ○ | ○ | ⓞ | Δ | × | ○ |
| Heat control Tolerance (min) | | 100 | 100 | 90 | 100 | 100 | 90 |
| Hardness | | 6H | 6H | 6H | 5H | 5H | 6H |
| Soldering heat Resistance | | ⓞ | ⓞ | ⓞ | Δ | ○ | ○ |
| Acid resistance | | ○ | ⓞ | ○ | ○ | ○ | Δ |
| Solvent resistance | | ⓞ | ⓞ | ⓞ | ⓞ | ⓞ | ⓞ |
| Gold-plating Resistance | | ⓞ | ⓞ | ○ | ○ | ○ | Δ |
| Electric Properties | | | | | | | |
| | Insulation Resistance (Ω) | 4.0 x 10¹² | 5.0 x 10¹² | 3.0 x 10¹² | 1.0 x 10¹² | 3.0 x 10¹² | 3.0 x 10¹¹ |
| | Discoloration | ⓞ | ○ | ○ | ○ | ○ | Δ |

It will be recognized from the results of Table 1 that in the case of Comparative Example 1 using a resin corresponding to the (A) component and obtained in the same manner as the present invention except that only the bisphenol type epoxy resin was employed without employing triglycidyl isocyanurate, it was impossible to obtain excellent results with regard to the anti-tackiness and acid resistance. Further, in the case of Comparative Example 2 using a resin which was obtained in the same manner as Comparative Example 1 except that the epoxy equivalent of the bisphenol type epoxy resin employed therein was as low as not more than a half of that of Comparative Example 1, it was impossible to obtain excellent results with regard to the anti-tackiness. Furthermore, in the case of Comparative Example 3 using a resin corresponding to the (A) component and obtained in the same manner as the present invention except that only the triglycidyl isocyanurate was employed without employing the bisphenol type epoxy resin, it was impossible to obtain excellent results with regard to the acid resistance and gold-plating resistance.

Whereas in the cases of Examples 1 to 3 where the resin of (A) component which was obtained by making use of, as an epoxy compound, a mixture comprising triglycidyl isocyanurate and a bisphenol type epoxy resin was employed, it was possible to obtain excellent results with regard to all of the features as described above. Among them, in the cases where the mixing ratio between the bisphenol type epoxy resin and the triglycidyl isocyanurate was set to about 2: 1 (Example 1), about 1:1 (Example 2), and about 1:2 (Example 3), any one of them is superior to the other two with respect to "discoloration" in the electric property, to acid resistance or to anti-tackiness. Further, the former two examples were much superior to the last example with respect to the gold-plating resistance, indicating that the cured film to be derived from the former two examples would be prominently excellent in flexibility and adhesivity.

In the cases of Comparative Examples 1 to 3, they employed reaction products which were obtained through a process wherein a single kind of epoxy resin was reacted with acrylic acid and then with hexahydrophthalic anhydride. Therefore, these reaction products were simply provided, on their skeletons, benzene ring which was originated from each epoxy resin. Whereas, in the cases of the reaction products where predetermined two kinds of epoxy compounds (epoxy resins) employed in the above examples were reacted with acrylic acid in such a manner that the number of carboxylic group became smaller relative to epoxy group, and then reacted with hexahydrophthalic anhydride to obtain the reaction products, the skeleton of the resultant polymer was provided not only with the benzene ring originating from the one kind of epoxy resin but also with isocyanuric ring originating from another kind of epoxy resin. Therefore, since this skeleton was provided with these two kinds of ring structures, a coated film of the solder resist compositions employing these resins would be improved in various features such as anti-tackiness (not sticky), soldering heat resistance on the occasion where the cured film is contacted with a fused solder, and the flexibility and adhesivity of the cured film.

By the way, the aforementioned expression of "photosensitive resin composition" may be replaced by other expressions such as " photosensitive resin composition for solder resist", or "printed wiring board covered with a solder resist film, and the manufacturing method thereof". Further, the present invention may be further limited by the aforementioned various values and other limiting features or by the combinations thereof.

As explained above, according to the present invention, it is possible to provide a photosensitive resin composition which is useful in forming an image by a process comprising a step of ultraviolet ray exposure and a step of development using a dilute aqueous alkaline solution, and is excellent not only in anti-tackiness (dry to touch) but also in film properties such as flexibility, adhesiveness and heat resistance without other film properties being sacrificed, i.e. other film properties being also maintained at an excellent level, thereby rendering the photosensitive resin composition suitable for forming a pattern of coated film. It is also possible according to the present invention to provide a photosensitive resin composition which is capable of markedly improving "discoloration" in the electric property, the anti-tackiness and especially the flexibility and adhesivity thereof so as to make it possible to satisfactorily perform a gold plating, thereby providing a photosensitive resin composition whose characteristics can be easily designed in conformity with the end use thereof.

It is also possible according to the present invention to provide a printed wiring board with or without an electronic component being mounted thereon, the printed wiring board being provided with a cured solder resist film constituted by the aforementioned photosensitive resin compositions.

## Claims

1. A photosensitive resin composition comprising (A) an active energy ray-curable resin having ethylenic unsaturated linkage, (B) a photopolymerizationinitiator, (C) a diluent, and (D) a thermosetting compound;
wherein said active energy ray-curable resin having ethylenic unsaturated linkage (A) comprises a polybasic acid-modified unsaturated monocarboxylic acid-modified composite epoxy resin which is obtained by a process wherein a mixture comprising triglycidyl isocyanurate and a bisphenol type epoxy resin is allowed to react with a radically polymerizable unsaturated monocarboxylic acid to produce a compound having hydroxyl group with which a saturated or unsaturated polybasic acid or a saturated or unsaturated polybasic acid anhydride is reacted to obtain said polybasic acid-modified unsaturated monocarboxylic acid-modified composite epoxy resin.

2. The photosensitive resin composition according to claim 1, wherein said active energy ray-curable resin having ethylenic unsaturated linkage (A) has an acid value ranging from 50 to 180 mgKOH/g.

3. The photosensitive resin composition according to claim 1 or 2, wherein the mixing ratio of triglycidyl isocyanurate in the mixture comprising triglycidyl isocyanurate and bisphenol type epoxy resin is within the range of 30 to 90%.

4. The photosensitive resin composition according to any one of claims 1 to 3, wherein said radically polymerizable unsaturated monocarboxylic acid is reacted with the mixture comprising triglycidyl isocyanurate and bisphenol type epoxy resin at a ratio of 0.4 to 0.9 mole per mole of the epoxy group of said mixture.

5. The photosensitive resin composition according to any one of claims 1 to 4, wherein said radically polymerizable unsaturated monocarboxylic acid is reacted with the mixture comprising triglycidyl isocyanurate and bisphenol type epoxy resin to produce a reaction product having hydroxyl group with which a saturated or unsaturated polybasic acid or a saturated or unsaturated polybasic acid anhydride is reacted at a ratio of 0.7 to 2.0 moles per mole of the hydroxyl group of said reaction product.

6. The photosensitive resin composition according to any one of claims 1 to 5, wherein said photopolymerization initiator (B) is employed at a ratio of 0.2 to 30g based on 100g of said active energy ray-curable resin having ethylenic unsaturated linkage (A).

7. The photosensitive resin composition according to any one of claims 1 to 6, wherein said diluent (C) is at least one kind of material selected from the group consisting of photopolymerizable monomers and organic solvents and is employed at a ratio of 2 to 40g based on 100g of said active energy ray-curable resin having ethylenic unsaturated linkage (A).

8. The photosensitive resin composition according to any one of claims 1 to 7, wherein said thermosetting compound (D) is constituted by an epoxy compound with or without other kind(s) of thermosetting compound(s) and is employed at a ratio of 5 to 100g based on 100g of said active energy ray-curable resin having ethylenic unsaturated linkage (A).

9. A printed wiring board with or without an electronic component being mounted thereon, the printed wiring board being covered with a solder resist film constituted by a cured film of the aforementioned photosensitive resin composition as set forth in any one of claims 1 to 8.
